# EUROPEAN PATENT APPLICATION

(11) **EP 0 874 443 A1**
(43) Date of publication of application: **28.10.1998**
(21) Application number: 98106810.9
(22) Date of filing: 15.04.1998
(51) Int. Cl.: H02K 9/18

(54) **Cooling system for an electrical and/or electronic apparatus cabinet**

(30) Priority: 24.04.1997 IT MI970969
(71) Applicant: Tecno Engineering S.p.A., 20121 Milan (IT)
(72) Inventor: Autuori, Antonio, 20142 Milan (IT)
(74) Representative: Gervasi, Gemma, Dr.

(57) **Abstract**

A cooling system for an electrical and/or electronic apparatus cabinet is described.

The cabinet comprises a first circuit (through which circulates the first air flow (6) cooling the electrical and/or electronic apparatus placed inside the cabinet) and a second circuit through which circulates a second air flow (4) coming form the external environment and being discharged into the external environment. The two air flows (4,6) have a coutercurrent heat exchange inside a heat exchanging means (1) consisting (preferably but not necessarily) of at least an heat recuperator.

## Description

### Field of the invention

The invention refers to cooling system for an electrical and/or electronic apparatus cabinet. The cabinet comprises a first circuit (through which circulates the air flow cooling the electrical and/or electronic apparatus which is placed inside the cabinet) and a second circuit through which circulates an air flow which comes from the external environment and is put in the external environment again. The two air flows have a countercurrent heat exchange inside the heat exchanging means consisting (preferably but not necessarily) of at least one heat recuperator.

### Prior Art

Cooling systems of electrical and/or electronic apparatus cabinets are already known. In these systems an air flow is sucked from the external environment by one or more fans (or by equivalent means), and passes through the said apparatus so removing heat therefrom before to be discharged again into the external environment.

These known cooling systems present a deficiency because they bring air sucked from the external environment into contact with the apparatus. This air has (or may have) chemical and physical properties (particulate, moisture, salt content, etc..) which damage (or may damage) the reliability and/or reduce the average life time of said apparatus.

The use of expensive elements (filters, dehumidifiers, etc..) is generally needed to overcome said drawback, these elements causing a relevant power absorption and involving more or less frequent maintenance operations.

Cooling systems for an electrical and/or electronic apparatus cabinets are also known which comprise a cooling circuit by which the heat produced by the apparatus is removed directly and/or by an air flow passing through said apparatus and through at least one part of the cooling system.

These cooling systems are expensive, cause a relevant power absorption and need more or less frequent maintenance operations. Furthermore, when the air flow (or at least one of the air flows) is sucked from the external environment, expensive elements are generally needed (filters, dehumidifiers, etc..) which cause a relevant power absorption and involve more or less frequent maintenance operations.

The object of the present invention is a cooling system for an electrical and/or electronic apparatus cabinet which is simple, efficient and inexpensive to be manufactured and operated.

### Summary of the invention

The object of the present invention is a cooling system for an electrical and/or electronic apparatus cabinet comprising in combination:
- a first circuit, through which passes a first air flow generated by first ventilation means and which cools the electrical and/or electronic apparatus placed inside the internal chamber of the cabinet;
- the first ventilation means generating the first air flow by sucking the air from the internal chamber of the cabinet and putting again the air in the above said internal chamber;
- a second circuit isolated in respect of the first one, through which passes a second air flow generated by second ventilation means;
- second ventilation means generating the second air flow by sucking the air from the external environment and discharging it in the external environment;
- heat exchange means through which the first and the second air flows countercurrent circulate inside the heat exchange means. Preferably but not necessarily, the heat exchange means consist of at least one heat recuperator.

### List of drawings and detailed description of the invention

A cooling system for electrical and/or electronic apparatus according to the invention will be hereinafter described with reference to a preferred embodiment given as a non limitative example and illustrated in the annexed figure, where are shown:
- the cabinet 7, inside the internal chamber 5 of which the electrical and/or electronic apparatus to be cooled are placed. The apparatus are not shown for the sake of graphical simplicity and because they are unrelated with the present invention;
- a first circuit, through which a first air flow 6 generated by first ventilation means 2 passes, and which cools the electrical and/or electronic apparatus placed inside the internal chamber 5 of the cabinet 7;
- the first ventilation means 2 generating the first air flow by sucking the air from the internal chamber 5 of the cabinet 7 and discharging the air into the above said internal chamber 5;
- a second circuit isolated in respect of the first one, through which passes a second air flow 4 generated by second ventilation means 3;
- second ventilation means 3 generating the second air flow by sucking the air from the external environment of the cabinet 7 and discharging it into the external environment;
- heat exchange means 1 through which the first and the second air flows pass and countercurrent circulate inside the heat exchange means 1.

The inlets of the first and of the second air flow 4,6 are preferably orthogonal one to the other and present an inclination of 45°C in respect of the horizontal plane.

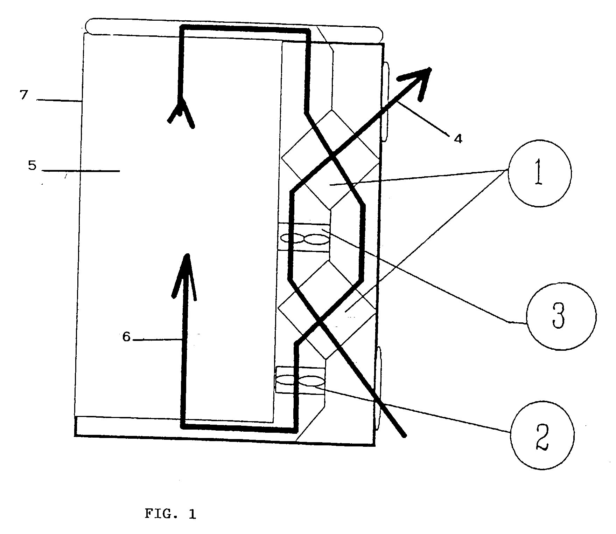

Furthermore in the embodiment shown in the figure, two heat exchange means are shown but one, three or more heat exchange means can be used without going beyond the scope of the invention.

Preferably but not necessarily, the heat exchange means 1 consists of at least one circuit element generally utilised as heat recuperator; however, it is also possible to realise the heat exchange means 1 by at least one heat exchanger.

Heat recuperators and exchangers will not be here described because they are well known to the skilled in the art and because they are preferably of commercial type and are unrelated with the present invention.

The first and second ventilation means 2,3 consist of at least one fan, preferably but not necessarily of the axial type. Advantageously, the first and second ventilation means 2,3 are obtained by a couple of parallel fans arranged according to a redundant configuration which increases the system reliability avoiding (or drastically reducing) the risk that a failure of at least one of the ventilation means 2,3 would cause the system failure.

The average temperature of the internal chamber 5 of the cabinet 7 can be easily adjusted by varying the rotation speed (and thus the flow) of the sole second ventilation means 3 of the second circuit and by keeping constant the flow of the first ventilation means of the first circuit and, as a consequence, keeping also constant the fluid dynamic characteristics of the first circuit which are specifically designed to remove in the best way also the heat which is generated inside the electrical and/or electronic apparatus.

The advantageous characteristics of a cooling system according the invention will be evident from the measurements carried out on two cooling systems having the structure schematically shown in the annexed figure.

The temperatures pointed out are the average temperatures detected during two tests performed at a room temperature of approximately 20 °C.

### Example 1

- Ventilation unit:: couples of axial flow fans Papst 2248.
- Power to be removed:: 1800 W.
- Exchange means:: heat recuperators "Recuperator"
Bl AL 03 N 044 L T SC
dimensions: 300X300X450 mm, pitch 8mm
- Temperatures:: first circuit inlet: about 27°C;
first circuit outlet: about 34°C;
second circuit inlet: 20.2 °C;
second circuit outlet: 27.8°C.
- Exchange system efficiency:: about 56%

### Example 2

- Ventilation unit:: couples of axial flow fans Papst 6248.
- Power to be removed:: 600 W.
- Heat exchange means:: heat recuperators "Recuperator"
Bl AL 02 N 044 L T SC
dimensions: 200X200X450 mm, pitch 8mm
- Temperatures:: first circuit inlet: about 28.5°C;
first circuit outlet: about 30.5°C;
second circuit inlet: 20.8 °C;
second circuit outlet: 28.1 °C.
- Exchange system efficiency:: about 76%.

Without going beyond the scope of the invention the man skilled in the art can modify the cooling system for an electrical and/or electronic apparatus cabinet of the present description, as suggested by the day-by-day experience and by the evolution of science.

## Claims

1. Cooling system for an electrical and/or electronic apparatus cabinet, characterised in that it comprises, in combination,
• a first circuit, through which passes a first air flow (6) generated by first ventilation means (2), the air flow cooling the electrical and/or electronic apparatus placed inside the internal chamber (5) of the cabinet (7);
• said first ventilation means (2) able to generate the first air flow by sucking the air from the internal chamber (5) of the cabinet (7) and discharging again the air in the above said internal chamber (5);
• a second circuit, isolated in respect of the first one, through which passes a second air flow (4) generated by second ventilation means (3);
• said second ventilation means (3) able to generate the second air flow (4) by sucking the air from the external environment and discharging it in the external environment again;
• heat exchange means (1) through which pass the first and the second air flows (6,4), said first air flow (4) circulating countercurrent to said second air flow (6) inside the heat exchange means (1).

2. Cooling system according to claim 1, characterised in that said heat exchange means (1) consist of at least one heat recuperator.

3. Cooling system according to claim 1, characterised in that said heat exchange means (1) consist of at least one heat exchanger.

4. Cooling system according to claim 1, characterised in that the inlets of said first and second air flow (6,4) are orthogonal one to the other and present an inclination of 45° in respect of the horizontal plane.

5. Cooling system according to claim 1, characterised in that said first and second ventilation means (2,3) consist of at least one fan.

6. Cooling system according to claim 1, characterised in that said first and second ventilation means (2,3) consist of at least a couple of fans.

7. Cooling system according to claim 5 or 6, characterised in that said fans constituting said first and second ventilation means (2,3) are of the axial type.
